# EUROPÄISCHE PATENTSCHRIFT

(11) **EP 1 281 303 B1**
(45) Veröffentlichungstag und Bekanntmachung des Hinweises auf die Patenterteilung: **04.07.2007**
(21) Anmeldenummer: 01935994.2
(22) Anmeldetag: 25.04.2001
(51) Int. Cl.: H05K 7/20, H01L 23/373

(54) **ELEKTRONISCHES LEISTUNGSMODUL**
ELECTRONIC POWER MODULE
MODULE DE PUISSANCE ELECTRONIQUE

(30) Priorität: 08.05.2000 DE 10022341
(43) Veröffentlichungstag der Anmeldung: 05.02.2003
(73) Patentinhaber: SIEMENS AKTIENGESELLSCHAFT, 80333 München (DE)
(72) Erfinder: APFELBACHER, Walter, 92271 Freihung (DE); REICHENBACH, Norbert, 92224 Amberg (DE); GERSTENKÖPER, Heinrich, 59581 Warstein (DE); JÖRKE, Ralf, 59581 Warstein (DE); KRAUSE, Elmar, 59581 Warstein (DE); MEWISSEN, Gerhard, 64354 Reinheim (DE)
(86) Internationale Anmeldenummer: PCT/DE2001/001566
(87) Internationale Veröffentlichungsnummer: WO 2001/087032

(56) Entgegenhaltungen:
- GB-A- 2 051 474
- US-A- 4 385 310
- US-A- 4 504 886
- US-A- 4 853 828

## Beschreibung

Die Erfindung bezieht sich auf ein elektronisches Leistungsmodul, insbesondere für ein elektronisches Motorsteuergerät zum Sanftanlauf von Motoren, mit zwei elektrisch antiparallel geschalteten Halbleiterelementen und mit mindestens einem Kühlkörper zur Abführung der Verlustwärme der Halbleiterelemente.

Ein gattungsgemäßes elektronisches Leistungsmodul ist als Bestandteil einer leistungselektronischen Einheit für den Sanftanlauf von Motoren bekannt. Die leistungselektronische Einheit umfaßt hier eines oder mehrere elektronische Leistungsmodule, die für Kurzzeitbelastung ausgelegt sein müssen. Das elektronische Leistungsmodul dient zur Stromführung und -beeinflussung in einer Phase, d.h. je nachdem, ob ein einphasiges oder dreiphasiges Netz vorliegt, wird eine entsprechende Anzahl von elektronischen Leistungsmodulen benötigt.

Eine derartige leistungselektronische Einheit führt nur in der Anlaufphase des Motors Strom, der in der Betriebsphase von einem parallel geschalteten Schaltgerät übernommen wird.

Beim Sanftanlauf von Motoren beträgt der Strom nur einen Bruchteil des Direkteinschaltstromes des Motors. Typischerweise beträgt der Strom während des Anlaufs 25 % bis 75 % des Direkteinschaltstroms. Mit dem Sanftanlauf bei reduziertem Strom ergibt sich allerdings eine verlängerte Anlaufzeit des Motors im Vergleich zu der beim Direkteinschalten.

In der Anlaufphase entstehen in den Halbleitern der elektronisches Leistungsmodule sehr hohe Verlustleistungen. Durch geeignete Kombination aus Leistungsmodul bzw. Leistungshalbleiter und Kühlkörper muß gewährleistet sein, daß die für die Halbleiter zulässige Sperrschichttemperatur nicht überschritten wird, um deren Zerstörung zu vermeiden. Aufgrund beschränkter Platzverhältnisse im Schaltschrank ergibt sich zudem die Forderung, den Raumbedarf der elektronischen Leistungsmbdule zu minimieren.

Bekannt ist eine nicht druckschriftlich belegbare Ausführungsform eines elektronischen Leistungsmoduls, bei dem zwei einzelne Thyristoren antiparallel geschaltet und zwischen zwei symmetrische Kühlkörperhälften gepreßt sind. Eine der beiden Kühlkörperhälften ist mittig geteilt und die beiden Teile sind mit einer flexiblen, elektrisch leitfähigen Verbindung verbunden. Dies ermöglicht eine flächige Pressung der Thyristor-Scheibenzellen, auch bei unterschiedlicher Scheibenzellenhöhe. Die beiden Kühlkörperhälften dieses bekannten Leistungsteils, das sowohl für Kurzzeitbelastung als auch für Dauerbetrieb ausgelegt ist, sind Teil des Stromkreises und damit potentialbehaftet.

Die beim Sanftanlauf auftretende Kurzzeitbelastung verursacht in der Siliziumzelle eine sehr hohe Verlustleistung, die unmittelbar nach Belastungsbeginn zu einer Erwärmung der Scheibenzelle führt. Nach etwa 2 bis 5 sek. stellt sich eine konstante Temperaturdifferenz zwischen der Siliziumzelle und dem Kühlkörper ein, d.h. die Scheibenzelle befindet sich thermisch im eingeschwungenen Zustand, in dem nun nahezu die gesamte Verlustleistung zur Erwärmung des Kühlkörpers verwendet wird. Die Kühlung des Leistungsteils erfolgt hier mit einem Lüfter.

Der Erfindung liegt die Aufgabe zugrunde, ein elektronisches Leistungsmodul der oben genannten Art mit guter Wärmeabführung, hoher Speicherfähigkeit für die von den Halbleiterelementen im Sanftanlauf abgegebene Wärme bei einfachem Aufbau und geringem Raumbedarf zu schaffen.

Die Aufgabe wird durch mindestens zwei leitende Schienen, zwischen die die beiden Halbleiterelemente über eine Druckkontaktierung eingespannt sind, gelöst. Diese Ausführung hat den besonderen Vorteil, daß die leitenden Schienen nicht nur zur Stromführung dienen, sondern bei Ausführung aus einem Material mit einer hohen Wärmekapazität als Zwischenspeicher dienen können, von denen die Wärme an damit verbundene Kühlkörper weitergeleitet und abgeführt wird.

Vorteilhafte Weiterbildung der Erfindung sind den Unteransprüchen 2 bis 11 zu entnehmen.

Besonders vorteilhaft ist es, wenn die Halbleiterelemente als Halbleiterzellen ausgeführt sind, z.B. als Siliziumzellen.

Bestehen die beiden Schienen aus einem Material mit einer Wärmekapazität größer 1,8 Ws/K/cm³, wie z.B. Aluminium, so läßt sich hiermit eine entsprechend gute Wärmeabführung erreichen.

Hinsichtlich Strom- und Wärmeführung ist es allerdings besonders vorteilhaft, wenn die beiden Schienen aus Kupfer bestehen.

Vorteilhafter Weise besteht eine der beiden Kupferschienen aus hartem Kupfer. Diese Kupferschiene ist dann als Bestandteil einer Druckvorrichtung zur oben genannten Druckkontaktierung verwendbar.

Weiterhin erweist es sich als besonders vorteilhaft, wenn mit der harten Kupferschiene ein Kühlkörper verbunden ist, da sich hierbei eine Grenzfläche mit niedrigem Wärmeübergangswiderstand erreichen läßt.

Die zweite der beiden Kupferschienen besteht vorteilhafterweise aus Elektrolytkupfer, das vergleichsweise weich und verformbar ist.

Ist die zweite Kupferschiene in ihrem mittleren Bereich verjüngt, so lassen sich geringe Dickenunterschiede der Halbleiterelemente problemlos ausgleichen.

Ist das elektronische Leistungsmodul mit zwei weiteren baugleichen elektronischen Leistungsmodulen zu einer dreiphasigen Einheit zusammengebaut, die in Verbindung mit einem Schütz betrieben wird, so läßt sich hiermit ein Motor in der Anlaufphase und im Dauerbetrieb betreiben.

Ein Ausführungsbeispiel der Erfindung wird im folgenden anhand einer Zeichnung näher erläutert. Es zeigen:
- FIG 1: eine Seitenansicht eines erfindungsgemäßen, elektronischen Leistungsmoduls für Kurzzeit-belastung,
- FIG 2: eine weitere Seitenansicht eines erfindungs-gemäßen elektronischen Leistungsmoduls mit verbundenen Kühlkörper und
- FIG 3, 4, 5: Seitenansichten von elektronischen Leistungs-modulen mit unterschiedlicher Kontaktierung.

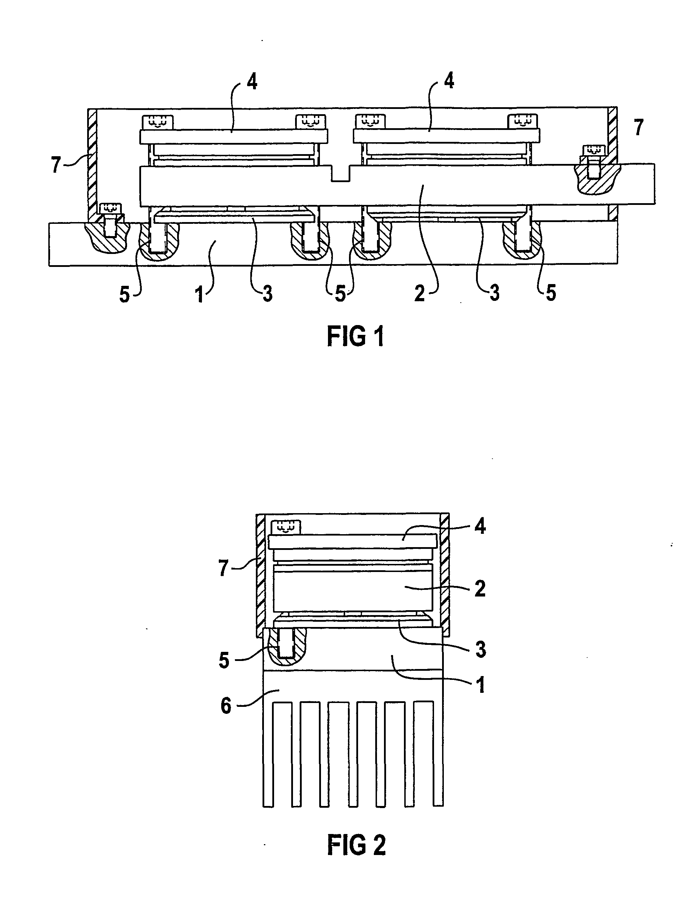

Das erfindungsgemäße elektronische Leistungsmodul gemäß FIG 1 weist zwei parallelangeordnete Kupferschienen 1, 2 auf, zwischen die zwei Siliziumzellen 3 als Halbleiterelemente eingebracht sind. Die Siliziumzellen 3 sind als Thyristoren ausgeführt und um 180° gedreht angeordnet, so daß sich eine elektrisch antiparallele Verschaltung ergibt. Anstelle von Thyristoren können beliebig andere Halbleiterbauelemente mit vergleichbarer Funktion eingebracht sein.

Die Kupferschienen 1, 2 erfüllen die Aufgabe, die während der hohen Kurzzeitbelastung auftretenden Wärmeverluste möglichst schnell von den Siliziumzellen 3 wegzuführen und zu speichern.

Aufgrund der hohen volumenspezifischen Wärmekapazität von ca. 3,4 Ws/K/cm³ und der hohen Wärmeleitfähigkeit ist als Material Kupfer besonders gut geeignet. Die sehr gute Wärmeleitfähigkeit von Kupfer stellt eine schnelle Abfuhr der Verlustwärme von der Siliziumzelle 3 sicher und führt gleichzeitig zu einer gleichmäßigen Verteilung und Erwärmung des restlichen Kupfers, welches sich nicht in unmittelbarer Nähe der Siliziumzelle 3 befindet. Gegenüber Aluminium als Material für die Schienen lassen sich die Abmessungen bei Verwendung von Kupfer wegen seiner ca. 1,5-fachen höheren volumenspezifischen Wärmekapazität um 1/3 Drittel reduzieren.

Grundsätzlich sind auch andere Materialien als Kupfer geeignet, sofern diese eine hohe Wärmeleitfähigkeit und eine hohe volumenspezifische Wärmekapazität aufweisen. Alternativ wäre z.B. auch eine Kombination aus Kupfer und einem latentwärmespeichernden Material einsetzbar, z.B. ein phase changing material (PCM).

Jede Siliziumzelle 3 ist über eine spezielle Druckvorrichtung 4 flächig zwischen die Kupferschienen 1 und 2 gepreßt. Das Pressen der Siliziumzellen 3 führt zu einem ganzflächigen Druckkontakt zwischen der Siliziumzelle 3 und den Kupferschienen 1 und 2 und hat einen geringen elektrischen und thermischen Übergangswiderstand an den Auflageflächen zur Folge.

Die Druckkontaktierung stellt eine hohe thermische Zyklenfestigkeit und damit Lebensdauer des Leistungsmoduls sicher, was wegen des ausschließlichen Betriebs mit Kurzzeitbelastung notwendig ist.

Die in FIG 1 untere Kupferschiene 1 besteht aus härterem Kupfer, die obere Kupferschiene 2 aus weichem Elektrolytkupfer. In die untere Kupferschiene 1 sind Gewinde 5 zur Montage der Druckvorrichtungen 4 eingebracht. Durch die Wahl des härteren Kupfers wird ein Durchbiegen der unteren Kupferschiene 1 in Folge der durch die Druckvorrichtung wirkenden Kräfte weitestgehend verhindert und ein flächiges Aufliegen der Siliziumzellen 3 gewährleistet. Außerdem wird ein Ausreißen oder Weglaufen der Gewinde 5 verhindert.

An die untere Kupferschiene 1 wird ein Kühlkörper 6 zum Beispiel durch eine Schraubverbindung befestigt (siehe FIG 2), um die während der Kurzzeitbelastung auftretenden Wärmeverluste abzuführen. Durch die Verwendung von härterem Kupfer ist zwischen der Kupferschiene 1 und dem Kühlkörper 6 ein weitgehend flächiger Kontakt und damit ein geringer thermischer Übergangswiderstand gegeben.

Die obere Kupferschiene 2 ist mittig verjüngt, um geringe Dickenunterschiede der Siliziumzellen 3 ausgleichen zu können. Dieser Effekt wird außerdem durch die Verwendung von weichem Elektrolytkupfer für die obere Kupferschiene 2 unterstützt. Diese Maßnahme gewährleistet einen ganzflächigen Druckkontakt zwischen den Siliziumzellen 3 und der oberen Kupferschiene 2. Auf eine Teilung der oberen Kupferschiene 2 gemäß dem Stand der Technik kann hier verzichtet werden. Durch den Wegfall von flexiblen, elektrischen Verbindungselementen zwischen den beim Stand der Technik vorhandenen Kupferschienenteilen kann demgegenüber die Bauhöhe des erfindungsgemäßen elektronischen Leistungsmoduls reduziert und der Montageaufwand verringert werden.

Der Kühlkörper 6 ist gemäß FIG 2 vorteilhafterweise elektrisch leitend mit der unteren Kupferschiene 1 verbunden. Hierdurch werden thermische Übergangswiderstände minimiert und eine sehr gute thermische Ankopplung des Kühlkörpers 6 an das Leistungsmodul erzielt. Der Kühlkörper 6 trägt somit mit seiner Wärmekapazität ebenfalls zur Vergrößerung der Kurzzeitbelastbarkeit bei.

Eine elektrisch isolierte Anbringung des Kühlkörpers 6 mit z.B. einer elektrisch isolierenden Folie ist ebenfalls möglich. Aufgrund des ca. 3 bis 5 mal höheren thermischen Übergangswiderstandes solcher Folien, verglichen dem bei direkter Anbringung wird der Beitrag des Kühlkörpers 6 zur Erhöhung der Kurzzeitbelastbarkeit reduziert.

Die obere Kupferschiene 2 ist geringfügig schmäler ausgeführt als die untere Kupferschiene 1. Dadurch kann ein Kunststoffgehäuse 7 um die obere Kupferschiene 2 und die Druckvorrichtung 4 angebracht werden, ohne die Baubreite des Leistungsmoduls zu vergrößern. In das Kunststoffgehäuse 7 wird anschließend eine Kunststoffmasse eingebracht, um die Spannungsfestigkeit zwischen den beiden Kupferschienen 1, 2 sicherzustellen. Die Kupferschienen 1, 3, die Halbleiterzellen 3 und die Druckvorrichtung 4 sind gemeinsam zu einem Modul vergossen.

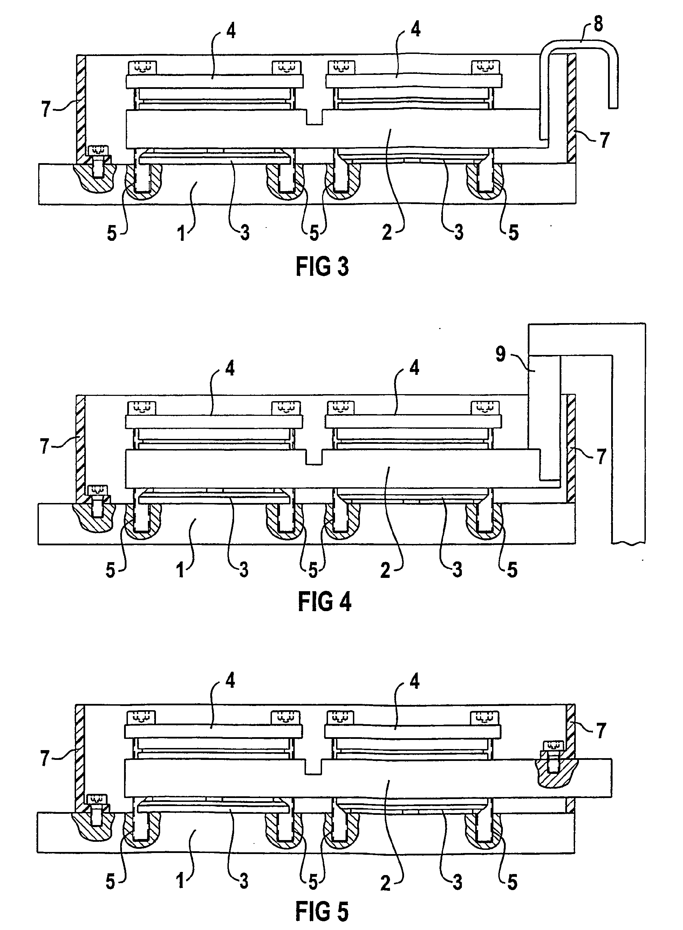

Die elektrische Kontaktierung kann an der unteren Kupferschiene 1 stirnseitig erfolgen. Der elektrische Anschluß an die obere Kupferschiene kann je nach Einbausituation gemäß FIG 3, 4, 5 unterschiedlich ausgeführt werden. In FIG 3 erfolgt die Kontaktierung der oberen Kupferschiene 2 innerhalb des Gehäuses 7 mittels eines U-förmig gebogenen Kupferflachmaterials 8. In FIG 4 wird hierzu ein am unteren Ende stufig geformtes, senkrecht nach oben führendes Kupferschienenstück 9 verwendet. FIG 5 zeigt einen stirnseitigen Anschluß beider Kupferschienen 1 und 2.

## Patentansprüche

1. Elektronisches Leistungsmodul, insbesondere für ein elektronisches Motor-Steuergerät zum Sanftanlauf von Motoren, mit zwei elektrisch antiparallel geschalteten Halbleiterelementen (3), und mit mindestens einem Kühlkörper (6) zur Abführung der Verlustwärme der Halbleiterelemente (3), **gekennzeichnet durch** mindestens zwei leitende Stromführende Schienen aus einem Material mit hoher Wärmekapazität (1,2) zwischen die die beiden Halbleiterelemente (3) über eine Druckkontaktierung (4) eingespannt sind so daß diese Schienen als Zwischen-speicher dienen von denen die Wärme an die damit Verbundene Kühlkörper (6) Weitergeleitet und abgeführt wird.

2. Elektronisches Leistungsmodul nach Anspruch 1, **dadurch gekennzeichnet, daß** die Halbleiterelemente als Halbleiterzellen (3) ausgeführt sind

3. Elektronisches Leistungsmodul nach Anspruch 2, **dadurch gekennzeichnet, daß** die beiden Schienen (1,2) aus einem Material mit einer Wärmekapazität größer 1,8 Ws/K/cm³ bestehen.

4. Elektronisches Leistungsmodul nach einem der vorangehenden Ansprüche, **dadurch gekennzeichnet, daß** die beiden Schienen (1,2) aus Kupfer bestehen.

5. Elektronisches Leistungsmodul nach einem der vorangehenden Ansprüche, **dadurch gekennzeichnet, daß** eine der beiden Kupferschienen (1,2) aus hartem Kupfer besteht.

6. Elektronisches Leistungsmodul nach Anspruch 5, **dadurch gekennzeichnet, daß** mit der harten Kupferschiene (1) ein Kühlkörper (6) verbunden ist.

7. Elektronisches Leistungsmodul nach Anspruch 6, **dadurch gekennzeichnet, daß** die harte Kupferschiene (1) mit dem Kühlkörper (6) elektrisch leitend verbunden ist.

8. Elektronisches Leistungsmodul nach Anspruch 6, **dadurch gekennzeichnet, daß** zwischen der harten Kupferschiene (1) und dem Kühlkörper (6) eine Isolierfolie liegt.

9. Elektronisches Leistungsmodul nach einem der vorangehenden Ansprüche, **dadurch gekennzeichnet, daß** die andere Kupferschiene (2) aus Elektrolytkupfer besteht.

10. Elektronisches Leistungsmodul nach Anspruch 9, d a-**durch gekennzeichnet**, daß die zweite Kupferschiene (2) in ihrem mittleren Bereich verjüngt ist.

11. Elektronisches Leistungsmodul nach einem der vorangehenden Ansprüche, **gekennzeichnet durch** eine Druckvorrichtung zum Aufbringen eines mechanischen Drucks, mit dem die Halbleiterelemente (3) eingespannt sind.

12. Elektronisches Leistungsmodul nach Anspruch 11, **dadurch gekennzeichnet, daß** die Schienen (1,2), Halbleiterelemente (3) und die Druckvorrichtung (4) zu einer Einheit miteinander vergossen sind.

## Claims

1. Electronic power module, in particular for an electronic motor control device for the smooth starting of motors, with two semiconductor elements (3) which are connected in an electrically antiparallel manner and with at least one heat sink (6) for dissipating the heat loss of the semiconductor elements (3), **characterized by** at least two conducting current carrying bars (1, 2) made from a material with a high thermal capacity, between which the two semiconductor elements (3) are clamped by means of pressure contacting (4), so that these bars serve as intermediate stores from which the heat is passed on to the heat sinks (6) connected to it and is dissipated.

2. Electronic power module according to claim 1, **characterized in that** the semiconductor elements are configured as semiconductor cells (3).

3. Electronic power module according to claim 2, **characterized in that** the two bars (1, 2) consist of a material with a thermal capacity greater than 1.8 Ws/K/cm³.

4. Electronic power module according to one of the preceding claims, **characterized in that** the two bars (1, 2) consist of copper.

5. Electronic power module according to one of the preceding claims, **characterized in that** one of the two copper bars (1, 2) consists of hard copper.

6. Electronic power module according to claim 5, **characterized in that** a heat sink (6) is connected to the hard copper bar (1).

7. Electronic power module according to claim 6, **characterized in that** the hard copper bar (1) is connected in an electrically conducting manner to the heat sink (6).

8. Electronic power module according to claim 6, **characterized in that** an insulating film lies between the hard copper bar (1) and the heat sink (6).

9. Electronic power module according to one of the preceding claims, **characterized in that** the other copper bar (2) consists of electrolytic copper.

10. Electronic power module according to claim 9, **characterized in that** the second copper bar (2) is made narrower in its central region.

11. Electronic power module according to one of the preceding claims, **characterized by** a pressing device for applying a mechanical pressure, by which the semiconductor elements (3) are clamped.

12. Electronic power module according to claim 11, **characterized in that** the bars (1, 2), semiconductor elements (3) and the pressing device (4) are encapsulated with one another to form a unit.

## Revendications

1. Module électronique de puissance, notamment pour un appareil électronique de commande de moteur pour faire démarrer les moteurs en douceur, comprenant deux éléments (3) à semi-conducteurs montés électriquement en opposition et au moins un dissipateur (6) de chaleur pour évacuer la chaleur perdue des éléments (3) à semi-conducteurs, **caractérisé par** au moins deux barres (1, 2) conductrices et de conduction du courant en un matériau ayant une grande capacité calorifique, entre lesquelles les deux éléments (3) à semi-conducteurs sont bloqués par une mise en contact (4) sous pression, de sorte que les barres servent d'accumulateurs intermédiaires à partir desquels la chaleur se propage sur les dissipateurs (6) de chaleur ainsi reliés et s'évacue.

2. Module électronique de puissance suivant la revendication 1,
**caractérisé en ce que** les éléments à semi-conducteurs sont réalisés en cellules (3) à semi-conducteurs.

3. Module électronique de puissance suivant la revendication 2,
**caractérisé en ce que** les deux barres (1, 2) sont en un matériau ayant une capacité calorifique supérieure à 1,8 Ws/K/cm³.

4. Module électronique de puissance suivant l'une des revendications précédentes,
**caractérisé en ce que** les deux barres (1, 2) sont en cuivre.

5. Module électronique de puissance suivant l'une des revendications précédentes,
**caractérisé en ce que** l'une des deux barres (1, 2) en cuivre est en cuivre dur.

6. Module électronique de puissance suivant la revendication 5,
**caractérisé en ce qu'**un dissipateur (6) de chaleur est relié à la barre (1) en cuivre dur.

7. Module électronique de puissance suivant la revendication 6,
**caractérisé en ce que** la barre (1) en cuivre dur est reliée d'une manière conductrice de l'électricité au dissipateur (6) de chaleur.

8. Module électronique de puissance suivant la revendication 6,
**caractérisé par** une feuille isolante entre la barre (1) en cuivre dur et le dissipateur (6) de chaleur.

9. Module électronique de puissance suivant l'une des revendications précédentes,
**caractérisé en ce que** l'autre barre (2) en cuivre est en cuivre électrolytique.

10. Module électronique de puissance suivant la revendication 9,
**caractérisé en ce que** les deux barres (2) en cuivre sont rétrécies dans leur partie médiane.

11. Module électronique de puissance suivant l'une des revendications précédentes,
**caractérisé par** un dispositif d'application d'une pression pour appliquer une pression mécanique par laquelle les éléments (3) à semi-conducteurs sont bloqués.

12. Module électronique de puissance suivant la revendication 11,
**caractérisé en ce que** les barres (1, 2), les éléments (3) à semi-conducteurs et le dispositif (4) d'application d'une pression sont coulés ensemble en une unité.
